# EUROPEAN PATENT APPLICATION

(11) **EP 1 914 816 A2**
(43) Date of publication of application: **23.04.2008**
(21) Application number: 07003020.0
(22) Date of filing: 13.02.2007
(51) Int. Cl.: H01L 51/52

(54) **Light emitting panel and light source apparatus having the same**

(30) Priority: 17.10.2006 KR 20060101086
(71) Applicant: LG ELECTRONICS INC., Seoul 150-010 (KR)
(72) Inventor: Lee, Ilho, Gumi-si Geyongsangbuk-do (KR)
(74) Representative: Katérle, Axel

(57) **Abstract**

A light emitting panel includes a substrate, a first electrode, an auxiliary electrode formed on the first electrode, a light emitting layer formed over the first and auxiliary electrodes, said light emitting layer defining an area of a light emitting region, and a second electrode formed over the light emitting layer where the auxiliary electrode is formed in a prescribed pattern.

## Description

### CROSS-REFERENCE

This application claims priority to and the benefit of Korea Patent Application No. 10-2006-0101086, filed on October 17, 2006, the entire contents of which is incorporated herein by reference.

### BACKGROUND

### 1. Field

One or more embodiments described herein relate to a light emitting panel.

### 2. Background

A light emitting panel is a self-emitting panel which typically has a low driving voltage and high light-emission efficiency. Thin-film and patterning processes may be easily performed to manufacture a light emitting panel of this type. However, because of a non-uniform distribution of resistances in the light emitting region, uneven brightness and excessive heat will tend to develop, thereby shortening the useable life of the panel. Improvements are therefore required.

### BRIEF DESCRIPTION OF THE DRAWINGS

The embodiments will be described in detail with reference to the following drawings in which like reference numerals refer to like elements, wherein:

Figs. 1A through 1E are plan and sectional diagrams showing a first embodiment of a process of a manufacturing a light emitting panel;

Figs. 2A through 2E are plan and sectional diagrams showing a second embodiment of a process of manufacturing a light emitting panel;

Figs. 3A through 3D are plan and sectional diagrams showing a third embodiment of a process of manufacturing a light emitting panel;

Fig. 4 is a diagram showing an embodiment of a display device that includes a display module and a backlight unit, the latter of which may correspond to any of the aforementioned embodiments of the light emitting panel;

Fig. 5 is a diagram showing an alternative orientation of mesh pattern for the auxiliary electrode that may be included in the light-emitting panel of Figs. 1A - 1E; and

Fig. 6 is a diagram showing an organic electroluminescent (EL) device according to an example arrangement.

### DETAILED DESCRIPTION

Light emitting panels are formed from a plurality of pixels, each comprised of a light emitting layer interposed between two electrodes. Electrons and holes provided from the two electrodes combine in the light emitting layer to generate excitons. When the energy level of the excitons changes from an agitated status to ground status, light is emitted.

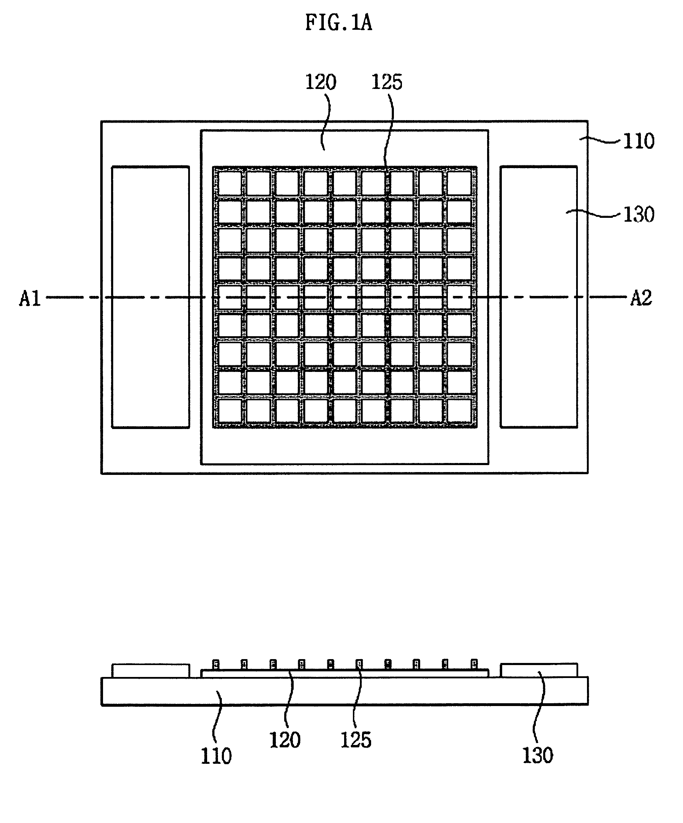

Figs. 1A through 1E are plan and sectional diagrams of a light emitting panel at different stages of a first embodiment of a manufacturing process. The sectional views are taken along the line A1-A2 of the plan views in each of Figs. 1A through 1E.

As shown in these figures, the light emitting panel includes a substrate 110 and a first electrode 120 formed on the substrate. The first electrode may be formed as one electrode and may be formed to include a transparent material with a high work function such as ITO (Indium Tin Oxide) or a flexible transparent material. Other electrode structures or materials may be used in different embodiments.

An auxiliary electrode 125 is disposed on the first electrode 120. The auxiliary electrode is formed to expose portions of the first electrode and is electrically connected to the first electrode. The auxiliary electrode may include first patterns arranged in a first direction, for example, in a direction from top to bottom, and are spaced apart from each other. According to one particular arrangement, the auxiliary electrode may be patterned in the shape of a stripe.

The auxiliary electrode may also, or alternatively, include second patterns arranged in a second direction, for example, in a direction from left to right, substantially perpendicular to the first direction. Accordingly, the auxiliary electrode may be patterned in the shape of a mesh. Fig. 5 shows an alternative orientation of a mesh pattern for the auxiliary electrode.

Through these arrangements, resistance at the first electrode 120 is minimized to effectively compensate for the phenomenon in which the amplitudes of the driving signal, which is applied to the first electrode 120, vary depending upon the location on the first electrode 120.

The auxiliary electrode 125 may be formed from metal having a conductivity higher than that of the first electrode 120, so as to minimize variation of resistance at the first electrode 120 depending upon the location on the first electrode. For example, auxiliary electrode 125 may be made from molybdenum (Mo), aluminum (Al), aluminum alloy, or any combination thereof.

Although Fig. 1A shows that the auxiliary electrode is formed from one layer, auxiliary electrode 125 may alternatively be formed from multiple layers. For example, electrode 125 may be formed from multiple layers that include in series molybdenum, aluminum, and molybdenum (Mo/Al/Mo).

Pads 130 may be formed along sides of the substrate at positions near the first electrode 120. The pads are also preferably insulated from the first electrode. Although Fig. 1A shows that pads 130 are formed at both sides of the first electrode, the location and number of the pads may be varied, depending, for example, on the structure and/or operating requirements of the light emitting panel.

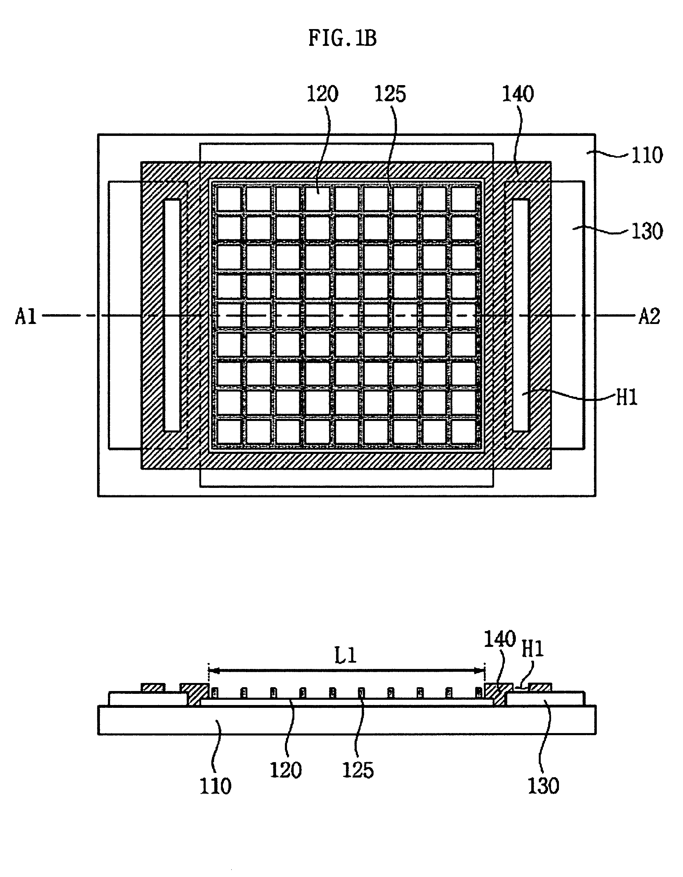

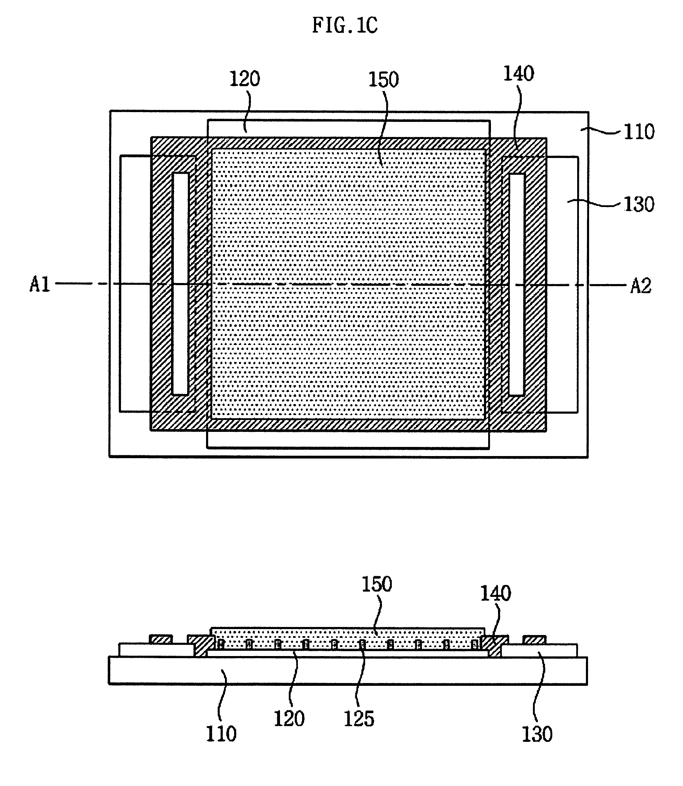

Referring to Figs. 1B and 1C, an insulation layer 140 is disposed on pads 130 and first electrode 120. A light emitting region L1, in which a light emitting layer 150 is formed, is disposed between the insulation layer 140. The insulation layer may be formed to have a hole H1 that exposes a portion of the pad 130.

The light emitting layer 150 is formed in the light emitting region L1 on top of the first electrode 120, at an area exposed by the insulation layer 140. Layer 150 may be an organic electroluminescent (EL) layer or another layer capable of emitting light in one or more colors

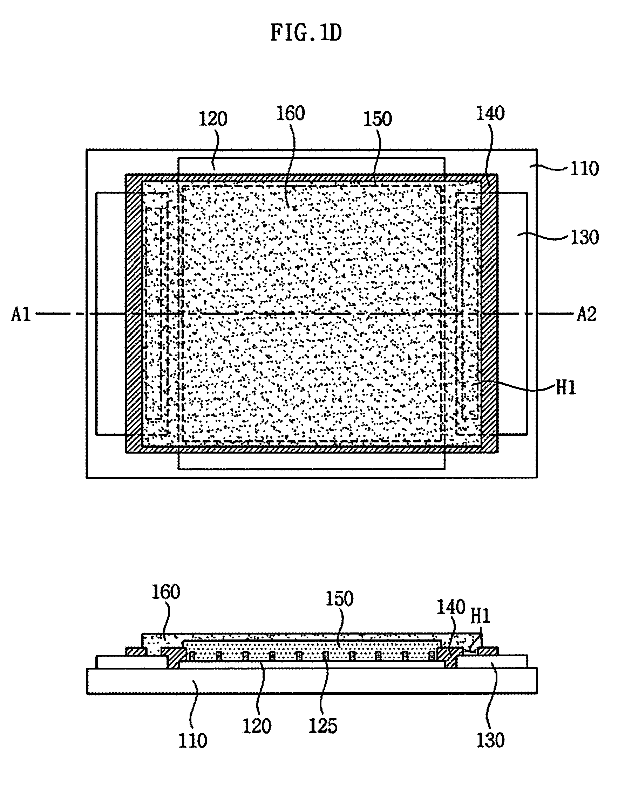

Referring to Fig. 1D, a second electrode 160 is formed on the light emitting layer 150. The second electrode 160 is preferably formed as one electrode and is electrically connected to pad 130 through hole H1.

The second electrode 160 may be formed from a metal having a work function lower than that of the first electrode. Such a metal may, for example, be aluminum or aluminum alloy. When the light emitting panel 100 is a top-emission type or a dual-emission (or both emission) type, second electrode 160 may be formed from a thin-metal or transparent electrode comprised of, for example, a thin metal and a transparent conduction layer.

Light emitting panel 100 formed according to the first embodiment may solve the problem of unevenness problem brightness due to variation in resistance in the light emitting region, since the driving signal may be transferred to the first electrode 120 through the pattern of the auxiliary electrode 125. A light emitting panel 100 according to the first embodiment may also prevent local heat damage at the light emitting layer 150. Especially when the light emitting panel 100 is used as a light source apparatus such as lighting equipment and a Back Light Unit (BLU), the driving period and brightness of the light emitting panel increases. The life span of the light emitting panel may therefore be increased since the pattern of auxiliary electrode 125 can prevent local heat damage at light emitting layer 150 that otherwise would be attributed to an increased driving period and uneven brightness.

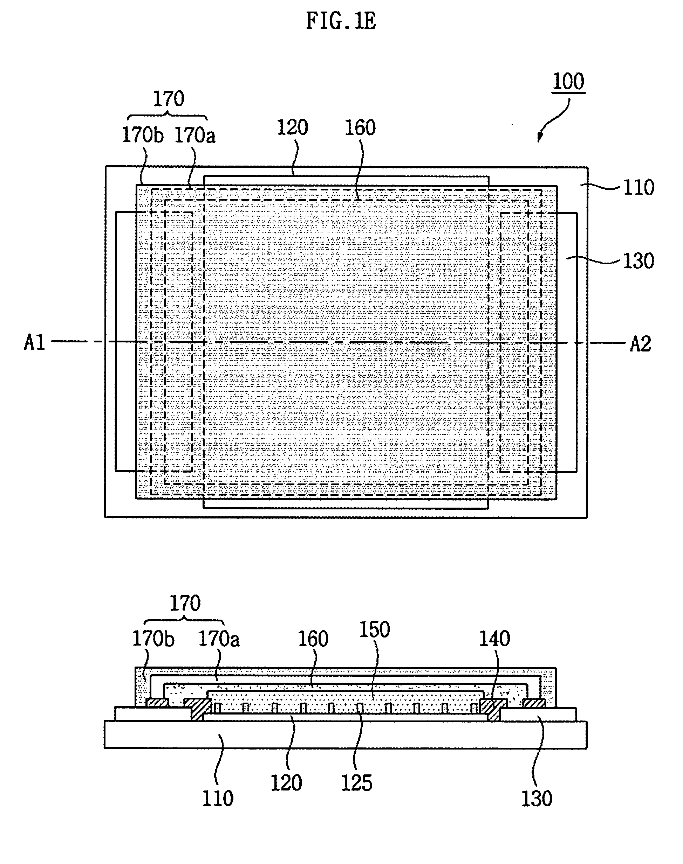

Referring to Fig. 1E, a passivation layer 170 is disposed on the second electrode 160 to protect inner portions 120, 130 and 150 of the light emitting panel 100 from external damage, deterioration due to external moisture or external oxygen.

The passivation layer 170 may include at least two passivation layers 170a and 170b to provide effective passivation of the light emitting panel 100.

The first passivation layer 170a may include metal having strong oxidation resistance and may compensate for the conductivity of second electrode 160. In addition, when the light emitting panel according to the first embodiment is a top-emission type or dual-emission (or both emission types), the first passivation layer 170a may be formed from a thin metal electrode or transparent electrode made from, for example, a thin metal electrode and transparent conduction layer.

The second passivation layer 170b may be formed from an inorganic substance suitable for preventing external moisture. The inorganic substance may be, for example, the same material as the insulation layer used for manufacturing the light emitting panel according to the first embodiment.

The light emitting panel according to the first embodiment does not require barrier ribs (or partition walls) since first and second electrodes 120 and 160 are respectively formed in one electrode. Thus, since the height difference due to the barrier ribs does not exist, the upper portion of second electrode 160 does not need to be planarized during the process of forming the passivation layers. Also, tact time for forming the passivation layers may be decreased.

The first passivation layer 170a and second passivation layer 170b may be selectively included in the structure of the passivation layer 170 of the light emitting panel according to the first embodiment.

Other passivation layer structures that may be used in place of or in conjunction with the aforementioned structure include, for example, only one of the first passivation layer 170a and second passivation layer 170b. According to additional alterations, first electrode 120 may correspond to an anode and second electrode 160 may correspond to a cathode, or the roles and materials of the first and second electrodes could be reversed or varied.

Also, although not shown, the light emitting panel according to the first embodiment may include a first wiring. This first wiring may be electrically connected to the first electrode 120 and may receive a first driving signal to transfer the first driving signal to the first electrode. In addition, the light emitting panel may include a second wiring electrically connected to the second electrode 160 via pads 130. The second wiring may receive a second driving signal in order to transfer the second driving signal to the second electrode 160.

The first and the second wirings may be respectively electrically connected to an end of the first electrode 120 and an end of the second electrode 160, and may respectively apply the first and second driving signals to first and the second electrodes 120 and 160.

Since the resistance at the light emitting region near the first and second wirings is lower than the resistance at the light emitting region relatively far from the first and second wirings, the voltage that is applied to the light emitting region relatively far from the first and second wirings is lower than the voltage applied to the light emitting region near the first and second wirings. As a result, the brightness of the light emitting region relatively far from the first and second wirings is lower than the brightness of the light emitting region near the first and second wirings.

The width or thickness of the auxiliary electrode 125 may also increase as the distance between the location of the auxiliary electrode and an end of first electrode 120, to which the first driving signal is applied, increases or as the distance between auxiliary electrode 125 and an end of second electrode 160, to which the second driving signal is applied, increases.

Also, the width or thickness of the pattern of the auxiliary electrode 125 may increase as the distance between the pattern of the auxiliary electrode and the first wiring increases. This may occur when the first wiring is formed at a first end of the first electrode 120 and the pattern of the auxiliary electrode is arranged between the first end of the first electrode, to which the first wiring is attached, and a second end of the first electrode, which faces the first end of the first electrode. The aforementioned structure of the auxiliary electrode may enhance uniformity of the brightness of the light emitting panel.

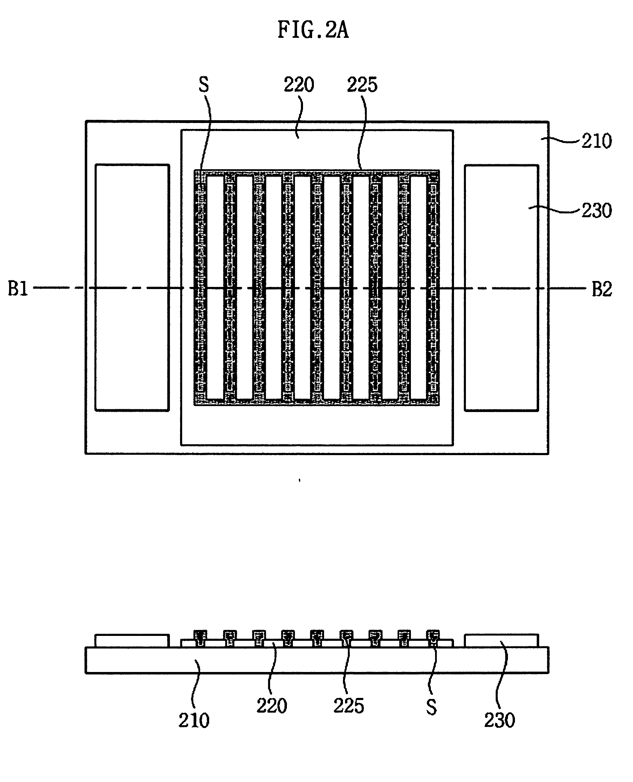

Figs. 2A through 2E are plan and sectional diagrams showing a light emitting panel at different stages of a second embodiment of a manufacturing process. As shown in these figures, the light emitting panel 200 includes a substrate 210 and a first electrode 220 formed on the substrate. The first electrode may be formed as one electrode and may be formed from a transparent material with a high work function such as ITO (Indium Tin Oxide) or a flexible transparent material. The first electrode may also be formed to include at least one slit (S) or groove or recess. The slit (S) or groove or recess is formed in the first electrode as shown in Fig. 2A. On the other hand, the slit (S) is formed to expose a portion of a side of the first electrode. For example, the first electrode may be fork -shaped or comb-shaped.

An auxiliary electrode 225 may be disposed in the slit (S) and may be electrically connected to the first electrode. The auxiliary electrode may also overlap or cover an edge portion near to the slit (S) of the first electrode. As shown, the auxiliary electrode is in a stripe pattern where the stripes in the pattern all have substantially a same width and length. The stripes are also shown as being vertically oriented. In alternative embodiments, the stripes may be horizontally oriented.

In this structure, the first electrode may be formed from a material having high resistance and the auxiliary electrode 225 may be formed from a material having low resistance. The presence of the one or more slits in the first electrode also has the effect of decreasing the overall area of this electrode. As a result, the total resistance of the first electrode 220 may be reduced.

In addition, when the auxiliary electrode is formed at the edge portion near the slit (S) of the first electrode, destruction (or breaking) of the light emitting layer 250, which is formed on the first electrode, due to an electric field concentrated on the edge portion near the slit (S) may be prevented.

The light emitting panel 200 may also solve the problem of unevenness of brightness of the panel due to variation of the resistance in the light emitting region.

For example, in other panels, the resistance at the light emitting region at a position near to an end of an electrode to which driving signal is applied may be lower than resistance at the light emitting region at a position relatively far from the end of the electrode to which the driving signal is applied. Consequently, the voltage applied to the light emitting region near the end of the electrode is higher than the voltage applied at the position far from the electrode. This will result in uneven brightness in the panel and excessive local heat damage.

One or more embodiments described herein may be applied to generate a predetermined (e.g., uniform) resistance across the light-emitting region of the panel. In the embodiment mentioned above, this may be accomplished by smoothly transferring the driving signal to the first electrode 220 through the predetermined pattern of the auxiliary electrode 225.

The light emitting panel 200 may also prevent local heat damage at the light emitting layer 250. Also, since the auxiliary electrode 225 of the light emitting panel is formed in the slit (S) of the first electrode, the thickness of the structure formed from the auxiliary and first electrodes may be reduced by an amount thinner than the thickness of the structure comprised of the auxiliary electrode 125 and the first electrode 120. Moreover, the conductivity of the structure formed from the auxiliary electrode and first electrode may be increased compared with that of the structure formed from auxiliary electrode and first electrode.

Although auxiliary electrode 225 has been previously discussed as being formed in the slit (S) of first electrode 220, in alternative embodiments the pattern of the auxiliary electrode could have various shapes. These shapes may be chosen to compensate for local unevenness of brightness at the light emitting layer 250. This compensation may be realized by smoothly transferring the driving signal to the first electrode 220 through the pattern of auxiliary electrode 225. Thus, for example, the auxiliary electrode may intersect the slit (S) or alternatively may be formed at a portion (or an end portion) which is near to the slit (S) of the first electrode 220.

Pads 230 are preferably formed at sides near to the first electrode 220 of substrate 210 and are insulated from the first electrode. Although not shown, a first wiring may be connected to the pads and the first driving signal may be applied to the first electrode 220 through the first wiring. Although Fig. 2A shows that pads are formed at both sides of the first electrode the location and number of the pads may be varied in alternative embodiments the structure of the light emitting panel.

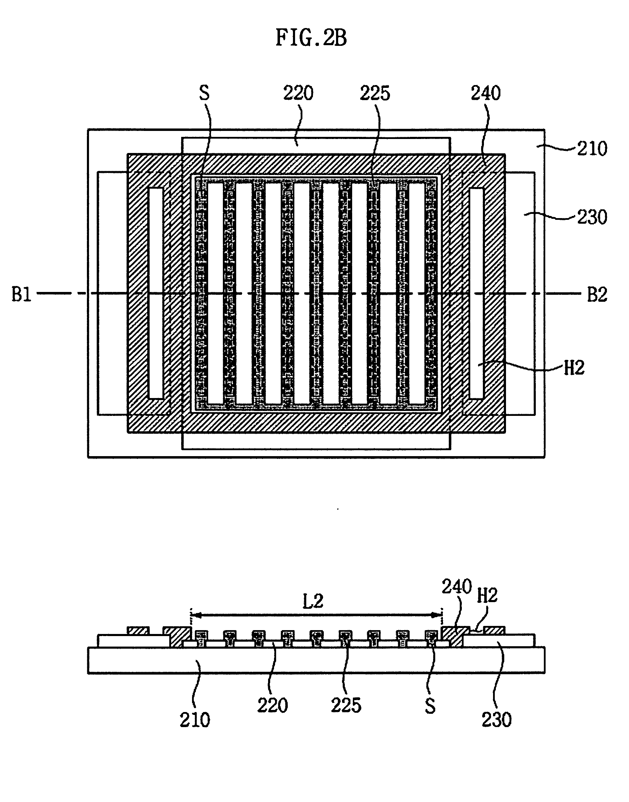

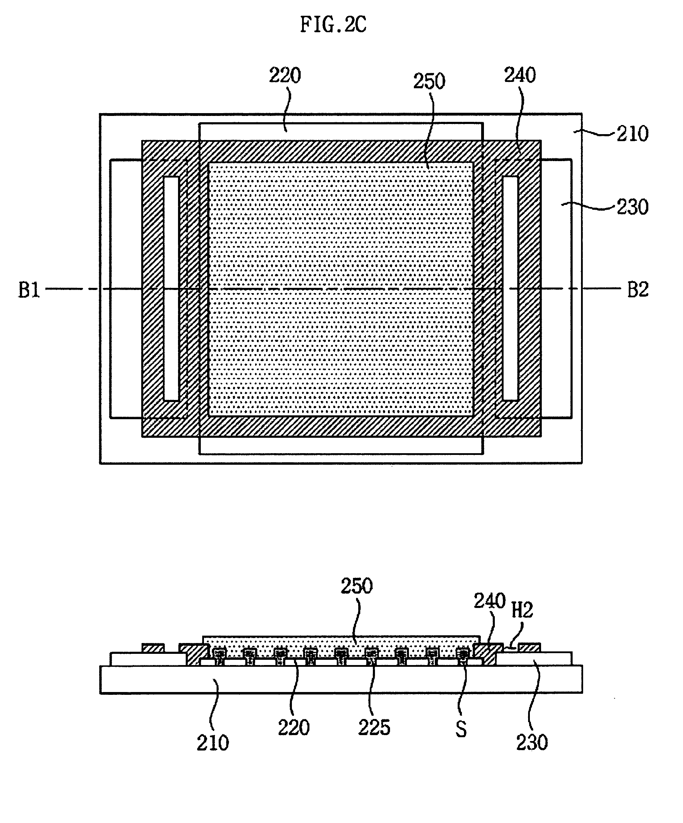

Referring to Figs. 2B and 2C, an insulation layer 240 is disposed on pads 230 and first electrode 220, and a light emitting region L2 in which a light emitting layer 250 is formed between sides of the insulation layer. The insulation layer may also have a hole H2 that exposes a portion of the pad 230. The light emitting layer 250 is formed in the light emitting region L2 on the first electrode 220 that is exposed by the insulation layer 240.

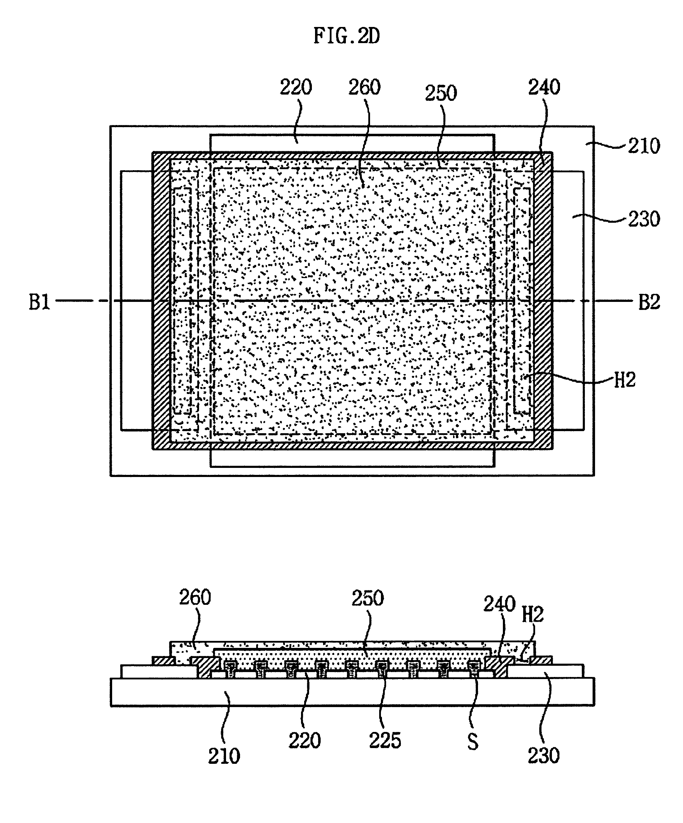

Referring to Fig. 2D, a second electrode 260 may be formed as one electrode on the light emitting layer 250 and the second electrode 260 is preferably electrically connected to the pad through hole H2. The first and second electrodes may be an anode and cathode respectively, or vice versa.

The second electrode 220 may be formed from metal with a work function lower than that of the first electrode 220, for example, aluminum or aluminum alloy. In addition, when the light emitting panel is a top-emission type or a dual-emission (or both emission) type, the second electrode 260 may be formed from a thin-metal electrode or transparent electrode formed from a thin metal and transparent conduction layer.

Referring to Fig. 2E, a passivation layer 270 may be disposed on the second electrode 260 to protect inner portions 220, 230 and 250 of the light emitting panel 200 from external damage, deterioration due to external moisture or external oxygen. According to one embodiment, the passivation layer may include at least two passivation layers 270a and 270b may be formed for the purpose of effective passivation. Alternatively, layer 270 may be formed from just one passivation layer.

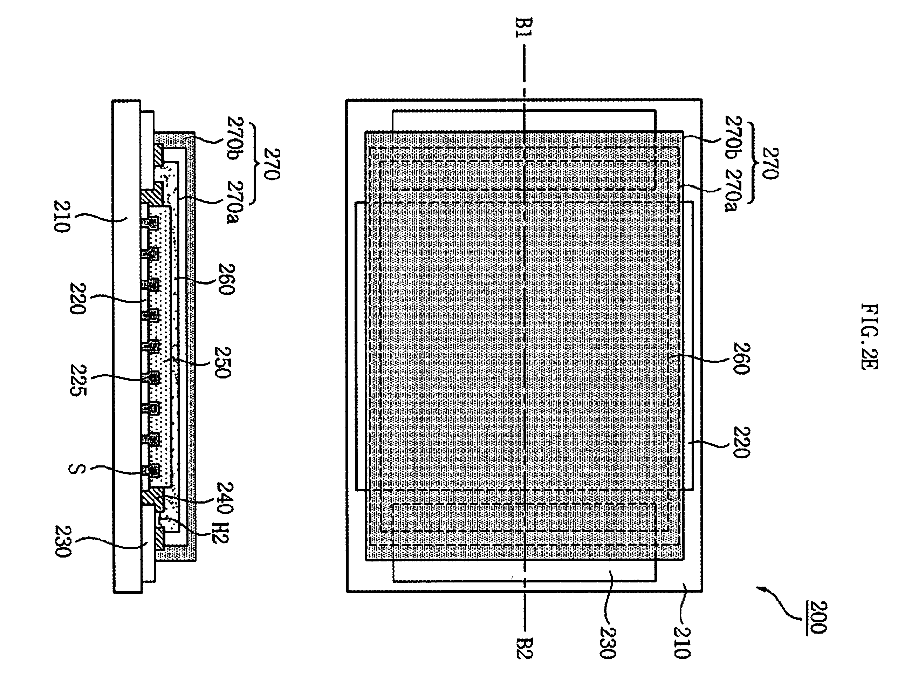

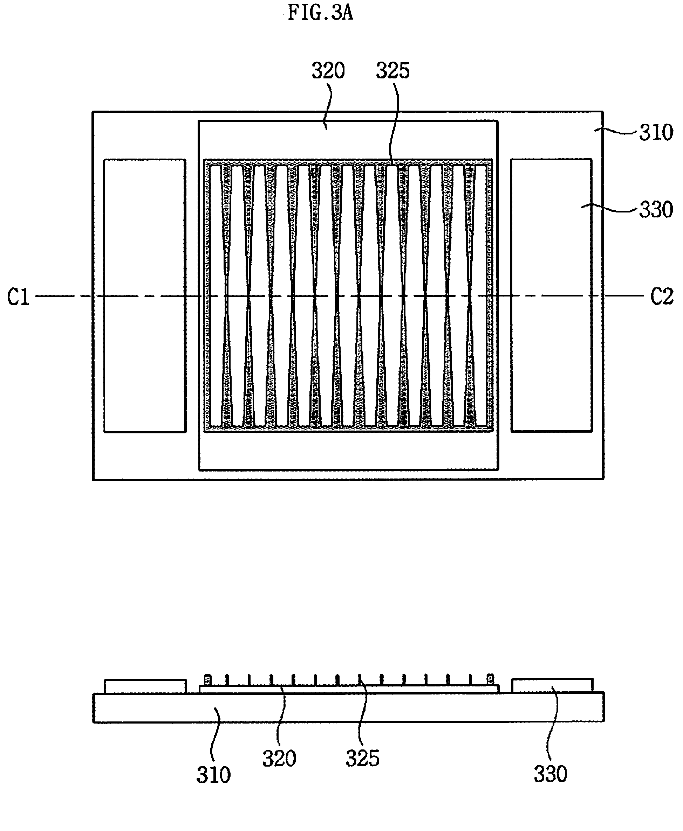

Figs. 3A through 3D are plan and sectional diagrams showing a light emitting panel at different stages of a third embodiment of a manufacturing process. As shown in these figures, the light emitting panel 300 includes a substrate 310 and a first electrode 320 formed on the substrate. The first electrode is preferably formed as one electrode and may be formed to include a transparent material with a high work function such as ITO (Indium Tin Oxide) or a flexible transparent material. Other electrode structures may be used in different embodiments.

A first wiring (not shown) may be electrically connected to both ends of the first electrode 320, and a first driving signal may be applied to the first electrode via the first wiring.

Pads 330 may be formed on both sides near to the first electrode of the substrate. These pads are electrically insulated from the first electrode. A second wiring (not shown) may be electrically connected to the pads and a second driving signal is preferably applied to a second electrode 360 via the second wiring.

When the first and second driving signals are applied to ends of the first electrode 320 and second electrode 360 respectively to which the first and second wiring is electrically coupled, the influence of the resistance of the electrodes on brightness of the light emitting region may be reduced, relatively uniform brightness may be obtained, and the reliability of the light emitting panel may be increased.

An auxiliary electrode 325 is disposed on the first electrode 320. The auxiliary electrode is formed to expose portions of the first electrode and is electrically connected to the first electrode. The auxiliary electrode may include first patterns arranged in a first direction, for example, in a direction from top to bottom (e.g., veritical), and are spaced apart from each other. According to one example, the auxiliary electrode may be patterned in the shape of a stripe. In an alternative embodiment, the stripes may be horizontally oriented.

The auxiliary electrode 325 may also include second patterns arranged in a second direction, for example, in a direction from left to right, substantially perpendicular to the first direction. This is, the auxiliary electrode 325 may be patterned in the shape of a mesh. As shown, the width or thickness of the auxiliary electrode increase as the distance between the location of the auxiliary electrode 325 and a center portion of the first electrode 320 increases. Uniform patterns other than stripe or mesh patterns may alternatively be used.

A center region of the light emitting panel 300 may be relatively brighter than other regions of the light emitting panel because the two first driving signals, applied from the ends of the first electrode 320, overlap at the center portion of the first electrode. Thus, the width or thickness of the auxiliary electrode 325 increases as the distance between the auxiliary electrode 325 and a center portion of the first electrode 320 increases, so that uneven brightness of the light emitting panel may be reduced.

The auxiliary electrode may be formed from a metal having a conductivity higher than that of the first electrode 320. This may reduce variation of resistance at the first electrode depending upon the location on the first electrode. By way of example, auxiliary electrode 325 may be one selected from the group consisting of molybdenum (Mo), aluminum (Al) and aluminum alloy or a combination thereof.

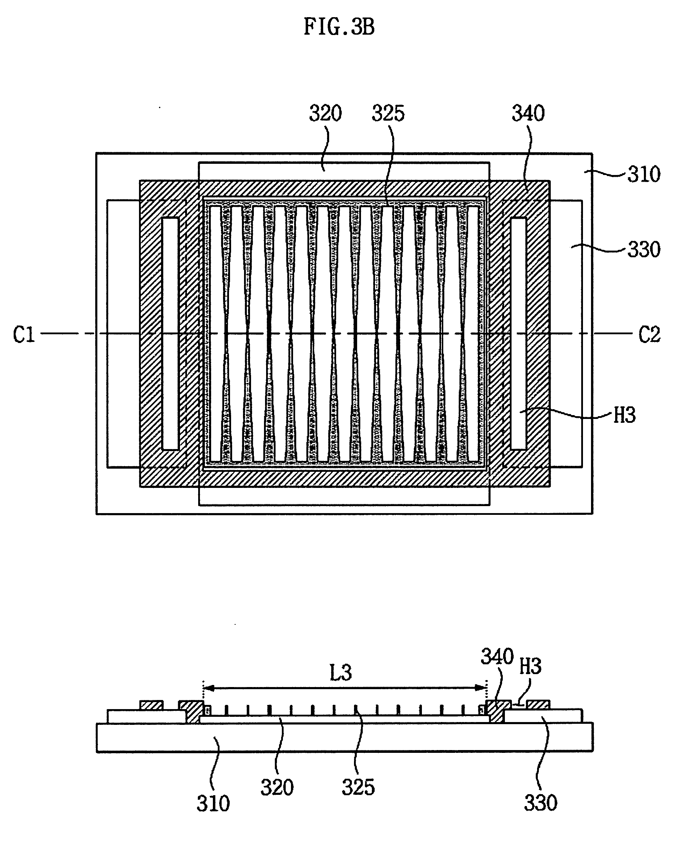

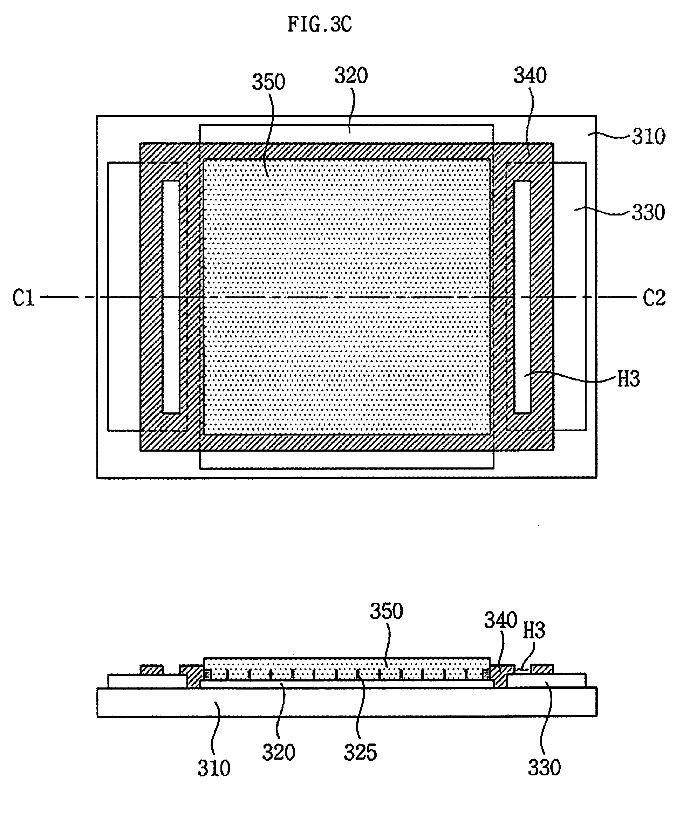

Referring to Figs. 3B and 3C, an insulation layer 340 is disposed on pads 330 and first electrode 320. A light emitting region L3, in which a light emitting layer 350 is formed, is disposed between sides of the insulation layer. The insulation layer may also have one or more holes H3 that expose respective portions of the pad 330. The light emitting layer 350 is formed on the light emitting region L3 on top of the first electrode 320 at areas exposed by the insulation layer 340.

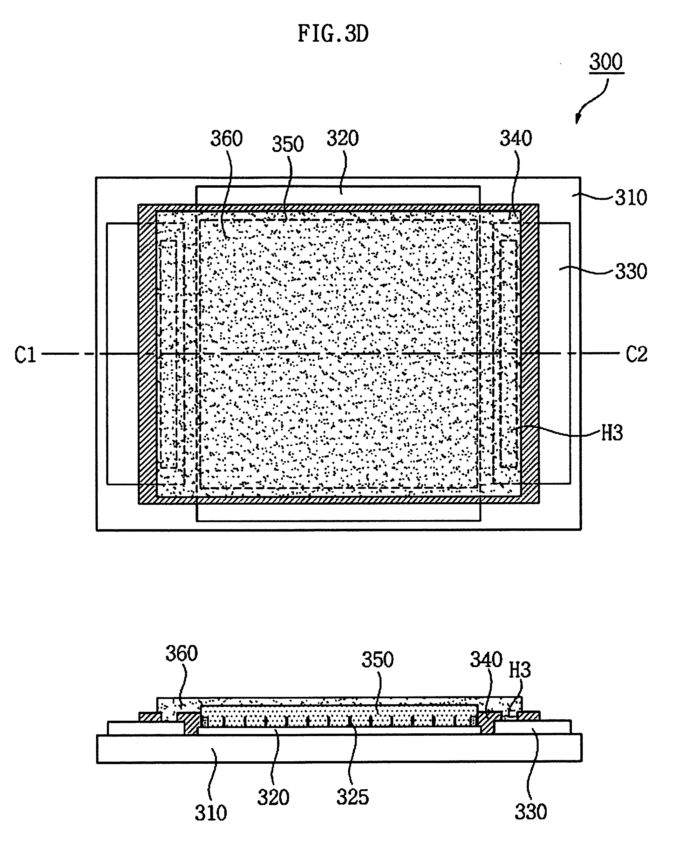

Referring to Fig. 3D, second electrode 360 is preferably formed as one electrode on the light emitting layer 350. The second electrode 360 may be electrically connected to each pad 330 through holes H3.

The light emitting panel 300 may solve problem of uneven brightness due to a variation in the resistance in the light emitting region, since the driving signal may be uniformly transferred to the first electrode 320 through the pattern of the auxiliary electrode 325. Also, the phenomenon, in which the brightness at the center region of the light emitting panel increases when the two first driving signals respectively applied from both ends of the first electrode 320, may be prevented because the width or thickness of the auxiliary electrode decreases as the distance between the auxiliary electrode 325 and the center portion of the first electrode 320 decreases.

In accordance with one or more embodiments described herein, the first driving signal may be a data signal and the second driving signal may be a scan signal. In addition, the first and second driving signals may be electrical signals that have positive or negative polarity and predetermined amplitudes.

Although the light emitting panels 100, 200 and 300 have light emitting layers 150, 250 and 350 respectively comprised of one layer, the light emitting layer could be comprised of at least two layers that emit different colors of light.

In addition, when the light emitting panel is used in a light source apparatus such as lighting equipment and a Back Light Unit (BLU), the light emitting layer may emit white light. Thus, the light emitting layer may be divided into one or more unit light emitting layers and each of the unit light emitting layer may have at least two layers. Blue, red and/or green colors may be combined with one another in order to provide the white light.

Although above example embodiments discuss that the auxiliary electrode is formed at the light emitting region where the insulation layer is exposed, the auxiliary electrode could be formed on the first electrode corresponding to non-emitting region that is adjacent to the light emitting region that is divided by the insulation layer. The light emitting layer may be comprised of, or include, one of organic material and inorganic material.

A light emitting panel according to the embodiments described herein may therefore prevent uneven brightness in a light emitting region due to a variation in resistance and local heat damage, and may also enhance reliability and the life span of the light emitting panel. While these properties are certainly advantageous, the embodiments may be constructed to achieve other benefits.

Also, one or more embodiments disclosed herein may correspond to or be used as a basis for forming a Back Light Unit (BLU), which, for example, may be of a type used to form a Liquid Crystal Display (LCD) or other display device.

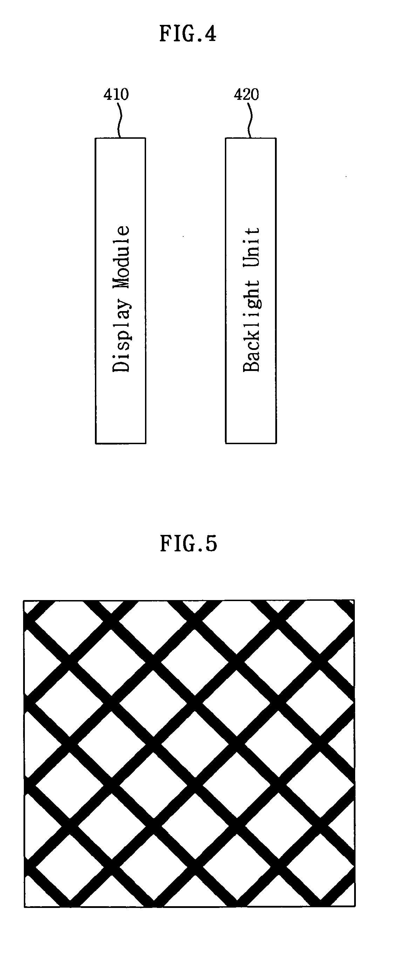

Referring to Fig. 4, a device according to another embodiment includes a display module 410 and a back light unit 420 disposed adjacent to the display module. The display module may, for example, be an LCD module. Such a display module is disclosed in greater detail in U.S. Patent No. 6,392,724. In alternative embodiments, module 410 may correspond to another display technology. The device of Fig. 4 may correspond to any device that includes or requires backlight.

The backlight unit may correspond to any of the embodiments of the light emitting panel previously described. Accordingly, the backlight unit may include a substrate, a first electrode, an auxiliary electrode formed on the first electrode, and a light emitting layer formed over the first and auxiliary electrodes. The light emitting layer may define an area of a light emitting region, and a second electrode may be formed over the light emitting layer. As previously indicated, the auxiliary electrode may be formed in a prescribed pattern including a mesh pattern, a stripe pattern having substantially constant-width stripes, or a stripe pattern having strips with varying widths.

The backlight unit serves as a light source for the display module and can be placed relatively anywhere due to the nature of the organic EL layer. Also, as previously indicated, the positions of the anode and cathode in the backlight unit are interchangeable in alternative embodiments.

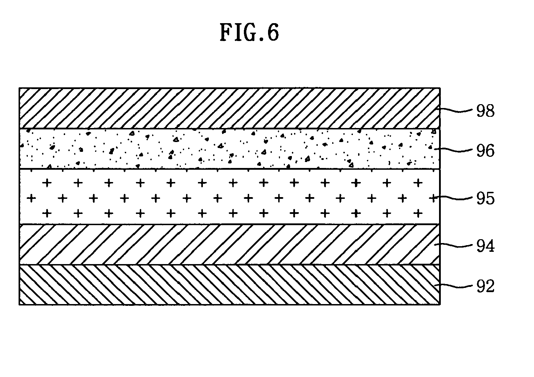

Fig. 6 shows details of the light emitting device, e.g., an organic electroluminescent device, according to an example arrangement.

The plurality of layers in Fig. 6 may correspond to the light emitting layer included in any one of the aforementioned embodiments. These layers include a hole injecting layer (HIL) 92 formed on an anode electrode layer, a hole transporting layer (HTL) 94 formed on the HIL 92, an organic electroluminescent layer 95 formed on the HTL 94, an electron transporting layer (ETL) 96 formed on the HTL 94 and an electron injecting layer (EIL) 98 formed on the ETL 96. A cathode electrode layer may be formed over the ETL 96.

One or more of the HIL, HTL, ETL and EIL may be omitted, depending on the particular device structure adopted. If the EIL layer is omitted, the cathode electrode layer may be formed directly on the ETL. Furthermore, an inorganic electroluminescent device may be used. Further, depending on the materials used for the cathode, anode and the substrate, the electroluminescent device can emit light through a transparent cathode, or through the transparent anode and substrate, or through both (bi-directional).

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments of the present invention have been described with reference to a number of illustrative embodiments thereof, it should be understood that numerous other modifications and embodiments can be devised by those skilled in the art that will fall within the spirit and scope of the principles of this invention. More particularly, reasonable variations and modifications are possible in the component parts and/or arrangements of the subject combination arrangement within the scope of the foregoing disclosure, the drawings and the appended claims without departing from the spirit of the invention. In addition to variations and modifications in the component parts and/or arrangements, alternative uses will also be apparent to those skilled in the art.

## Claims

1. A light emitting panel comprising:
a substrate;
a first electrode;
an auxiliary electrode formed on the first electrode;
a light emitting layer formed over the first and auxiliary electrodes, said light emitting layer defining an area of a light emitting region; and
a second electrode formed over the light emitting layer, wherein the auxiliary electrode is formed in a mesh pattern.

2. The light-emitting panel of claim 1, wherein the mesh pattern exposes portions of the first electrode in the light emitting region.

3. The light emitting panel of claim 1, wherein the first electrode is formed on the substrate.

4. The light emitting panel of claim 1, further comprising:
at least one pad; and
an insulation layer formed over the pad,
wherein the insulation layer includes a hole which exposes at least a portion of the pad and wherein the second electrode makes electrical contact with the pad through the hole.

5. The light emitting panel of claim 1, wherein the first electrode is an anode and the second electrode is cathode.

6. The light emitting panel of claim 1, wherein the light emitting layer is an organic electroluminescent layer.

7. The light emitting panel of claim 1, wherein the first electrode is a cathode and the second electrode is an anode.

8. The light emitting layer of claim 7, wherein the light emitting layer is an organic electroluminescent layer.

9. The light emitting panel of claim 1, wherein the panel is a top-emission panel.

10. The light emitting panel of claim 1, wherein the panel is a dual-emission panel.

11. A light emitting panel comprising:
a substrate;
a first electrode;
an auxiliary electrode formed on the first electrode;
a light emitting layer formed over the first and auxiliary electrodes, said light emitting layer defining an area of a light emitting region; and
a second electrode formed over the light emitting layer, wherein the auxiliary electrode is formed in a stripe pattern.

12. The light-emitting panel of claim 11, wherein said stripe pattern includes a plurality of stripes having substantially a same width.

13. The light-emitting panel of claim 11, wherein the stripe pattern exposes portions of the first electrode in the light emitting region.

14. The light emitting panel of claim 11, wherein the auxiliary electrode is formed in one or more slits formed in the first electrode.

15. The light emitting panel of claim 14, wherein the auxiliary electrode overlaps a top surface of the first electrode within the one or more slits.

16. The light emitting panel of claim 11, further comprising:
at least one pad; and
an insulation layer formed over the pad,
wherein the insulation layer includes a hole which exposes at least a portion of the pad and wherein the second electrode makes electrical contact with the pad through the hole.

17. The light emitting panel of claim 11, wherein the first electrode is an anode and the second electrode is cathode.

18. The light emitting panel of claim 11, wherein the light emitting layer is an organic electroluminescent layer.

19. The light emitting panel of claim 11, wherein the first electrode is a cathode and the second electrode is an anode.

20. The light emitting layer of claim 19, wherein the light emitting layer is an organic electroluminescent layer.

21. The light emitting panel of claim 11, wherein the panel is a top-emission panel.

22. The light emitting panel of claim 11, wherein the panel is a dual-emission panel.

23. A light emitting panel comprising:
a substrate;
a first electrode;
an auxiliary electrode formed on the first electrode;
a light emitting layer formed over the first and auxiliary electrodes, said light emitting layer defining an area of a light emitting region; and
a second electrode formed over the light emitting layer, wherein the auxiliary electrode is formed in a stripe pattern, said stripe pattern including a plurality of stripes having varying widths.

24. The light emitting panel of claim 23, wherein the width of each stripe at a center portion of the light emitting region is different from the width of each stripe at an end portion of the light emitting region.

25. The light emitting panel of claim 24, wherein the width of each stripe at the center portion is less than the width of each stripe at the end portion of the light emitting region.

26. The light-emitting panel of claim 23, wherein the stripe pattern exposes portions of the first electrode in the light emitting region.

27. The light emitting panel of claim 23, further comprising:
at least one pad; and
an insulation layer formed over the pad,
wherein the insulation layer includes a hole which exposes at least a portion of the pad and wherein the second electrode makes electrical contact with the pad through the hole.

28. The light emitting panel of claim 23, wherein the first electrode is an anode and the second electrode is cathode.

29. The light emitting panel of claim 23, wherein the light emitting layer is an organic electroluminescent layer.

30. The light emitting panel of claim 23, wherein the first electrode is a cathode and the second electrode is an anode.

31. The light emitting layer of claim 30, wherein the light emitting layer is an organic electroluminescent layer.

32. The light emitting panel of claim 23, wherein the panel is a top-emission panel.

33. The light emitting panel of claim 23, wherein the panel is a dual-emission panel.

34. A light source apparatus comprising:
a first electrode;
a second electrode;
an auxiliary electrode formed on the first electrode;
a light emitting layer provided between the first electrode and the second electrode, wherein the auxiliary electrode has a prescribed pattern and at least one of the first electrode or second electrode comprises a single electrode.

35. A display device comprising:
a display module; and
a back light unit, the back light unit having
a substrate;
a first electrode;
an auxiliary electrode formed on the first electrode;
a light emitting layer formed over the first and auxiliary electrodes, said light emitting layer defining an area of a light emitting region; and
a second electrode formed over the light emitting layer, wherein the auxiliary electrode is formed in a prescribed pattern.
